Europäisches Patentamt

European Patent Office

Office européen des brevets

(19)

(11) Veröffentlichungsnummer : **0 152 557**
**B1**

(12) **EUROPÄISCHE PATENTSCHRIFT**

(45) Veröffentlichungstag der Patentschrift :
01.02.89

(51) Int. Cl.⁴ : **H 01 L 23/48**

(21) Anmeldenummer : **84114326.6**

(22) Anmeldetag : **27.11.84**

(54) Halbleiterbauelement mit höckerartigen, metallischen Anschlusskontakten und Mehrlagenverdrahtung.

(30) Priorität : 30.11.83 DE 3343367

(43) Veröffentlichungstag der Anmeldung :
28.08.85 Patentblatt 85/35

(45) Bekanntmachung des Hinweises auf die Patenterteilung : 01.02.89 Patentblatt 89/05

(84) Benannte Vertragsstaaten :
AT DE FR GB IT

(56) Entgegenhaltungen :
DE--A-- 3 141 056
US--A-- 4 258 382
PATENTS ABSTRACTS OF JAPAN, Band 5, Nr. 159 (E-
77)[831], 14. Oktober 1981; & JP - A - 56 88 339
(HITACHI SEISAKUSHO K.K.) 17-07-1981

(73) Patentinhaber : Siemens Aktiengesellschaft Berlin
und München
Wittelsbacherplatz 2
D-8000 München 2 (DE)

(72) Erfinder : Pammer, Erich, Dr. rer.nat.
Platanenstrasse 59
D-8028 Taufkirchen (DE)

## Beschreibung

Die Erfindung betrifft ein Halbleiterbauelement mit höckerartigen, metallischen Anschlußkontakten und Mehrlagenverdrahtung nach dem Oberbegriff des Patentanspruchs 1.

Elektronische Halbleiterleiterschaltkreise müssen bekanntermaßen in Anwendungsfall mit den sonstigen Teilen einer elektrischen Schaltung verbunden werden, was z. B. durch Löt- oder Drahtverbindungen geschieht. Dabei wird jedoch wegen der Gefahr der Beschädigung im allgemeinen diese Verbindung nicht direkt am Halbleiterbauelement (Chip) eines solchen Halbleiterschaltkreises hergestellt, sondern an einem « Verbindungsstück ». Solch ein Verbindungsstück ist beispielsweise ein Kontaktfleck aud dem Träger einer sogenannten Micropack-Konstruktion. Diese Ausführung ist in der Halbleiterindustrie wohl bekannt. Sie vermeidet einen sonst notwendigen direkten mechanischen Zugriff des Bauelementkunden auf das Halbleiterbauelement des Halbleiterschaltkreises. Das dabei noch notwendige Verbinden des erwähnten Kontaktfleckes mit einem entsprechenden Anschlußkontakt auf dem Halbleiterbauelement selbst erfolgt noch durch dessen Hersteller, gleichzeitig in einem Arbeitsgang für alle Kontaktanschlüsse des Bauelementes. Diesen Vorgang nennt man Automatic Tape Bonding. Die Kontaktanschlüsse des Halbleiterbauelementes sind dabei als metallische Höcker ausgeführt, bestehen ggf. aus mehreren Materialien, von denen zumindest die oberste Schicht gut lötfähig oder thermokomprimierbar ist, und sind entweder aus Gold oder mit einer Goldschicht überzogen (Kontaktierung erfolgt über Thermokompression) oder bestehen mindestens an ihrer Oberfläche aus einem lötfähigen Material, wie Gold, Silber oder Kupfer, überzogen mit Zinn oder einer Blei-Zinn-Legierung. Sie können sich sowohl am Rande des Halbleiterbauelementes, dem sogenannten inaktiven Bereich, befinden oder aber auch in dessen aktivem Bereich.

Die zunehmende Komplexität und die steigende Integrationsdichte integrierter Halbleiterbauelemente hat dazu geführt, daß die Signal- und Potentialführung innerhalb dieser Bauelemente heute oft in der sogenannten Mehrlagentechnik erfolgt im Gegensatz zur früheren Einlagentechnik. Dabei werden die verwendeten elektrische Signale und Potentiale nicht mehr nur in einer Ebene geführt, sondern in mehreren, jeweils getrennt durch elektrisch isolierende Schichten, wie z. B. Siliziumdioxid, Siliziumnitrid, verschiedene Polyimide. Die Verbindung einzelner Lagen gleicher Signale bzw. Potentiale wird dabei in erster Linie im Bereich des jeweiligen Anschlußkontaktes durchgeführt.

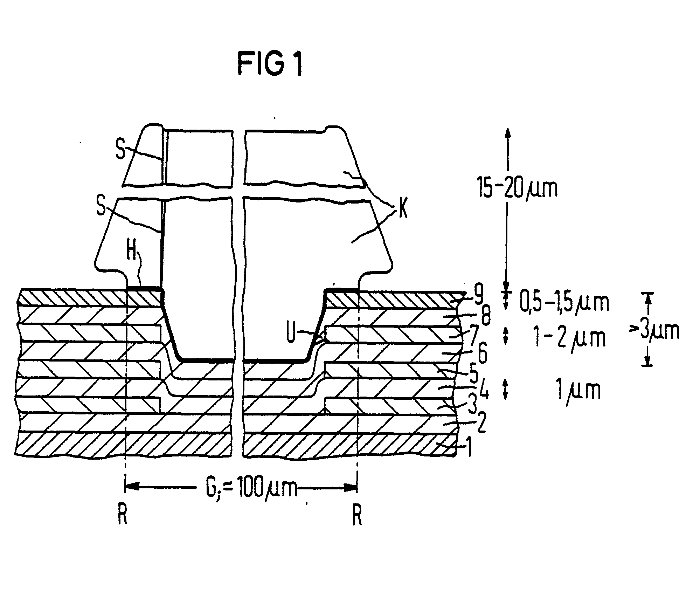

Bei bisher üblichen Halbleitertechnologien kommen dann, wie in Fig. 1 dargestellt, unter eine Grundfläche G der Anschlußkontakte K im wesentlichen folgende Schichten zu liegen :

1. elektrische Leitbahnen 2, 4, 6, 8 unter der gesamten Grundfläche G ;

2. Isolierschichten 3, 5, 7 in der Form, daß sie unter halb der Grundfläche G jeweils eine große Öffnung besitzen, innerhalb der Teile der Leitbahnen 4, 6, 8 liegen ;

3. auf der obersten Leitbahn 8 eine sog. Endpassivierungsschicht 9 ebenfalls mit einer großen Öffnung unterhalb der Grundfläche G.

Die Grundfläche G der Anschlußkontakte K ist dabei definiert als horizontale Schnittfläche durch einen Anschlußkontakt K in der Höhe, in der dieser die größte horizontale Ausdehnung auf der Endpassivierungsschicht 9 besitzt.

Bei der Herstellung des bekannten Halbleiterbauelementes werden die Isolierschichten 3, 5, 7 und die Endpassivierung 9 zunächst ganzflächig aufgebracht und dann in einem Teilbereich der Grundfläche G der später aufzubringenden Anschlußkontakte K wieder abgeätzt, so daß an diesen Stellen zylindrische bzw. quaderförmige Kontaktlöcher entstehen, die teilweise mit den Leitbahnen 4, 6, 8 der Mehrlagenverdrahtung, beispielsweise bestehend aus Aluminium, Aluminium mit bis zu 4 % Silizium- bzw. Kupferanteil, Metallfolien wie Titan, Platin, Gold und/oder elektrisch leitenden Siliziden, angefüllt sind. Die Leitbahnen 4, 6, 8 und die Isolierschichten 5, 7 bilden dabei aufgrund der Öffnungen in den Isolierschichten 3, 5, 7 Stufen mit mehr als 3 $\mu$m Höhe. Dies kann zu Leitbahnunterbrechungen U mit allen daraus folgenden Zuverlässigkeits- und Funktionsrisiken bis zum elektrischen Totalausfall führen.

Als oberste Schicht wird dann auf diese Anordnung im Bereich der Grundfläche G der später aufzubringenden Anschlußkontakte K durch Aufdampfen oder Sputtern eine 0,1 bis 2 $\mu$m dünne metallische Schichtfolge als Haftschicht H und Diffusionsbarriere zwischen der Leitbahn 8 und der Endpassivierungsschicht 9 einerseits und den künftigen metallischen, höckerartigen Anschlußkontakten K andererseits aufgebracht. Die Anschlußkontakte K selbst werden ganzflächig beispielsweise durch Bedampfen oder durch galvanische Abscheidung in Verbindung mit Fototechnikschritten erzeugt und im Falle der ganzflächigen Bedampfung in den Bereichen außerhalb der zu fertigenden Anschlußkontakte K wieder abgeätzt. Dabei entstehen jedoch aufgrund der vorgenannten Stufenhöhen größer 3 $\mu$m und ausgehend von den seitlichen Rändern der Kontaktlöcher, vertikal nach oben durch die Anschlußkontakte K verlaufende sogenannte Bedampfungsspalte S bzw. Fehlstellen, an denen dann Ätzmittel und Elektrolyte eindringen können, was zu Kontaktverätzungen, Korrosion und anschließendem elektrischen Ausfall des Halbleiterbauelementes führt.

Aus DE-A 3141056 ist eine Halbleitervorrichtung mit höckerartigen Anschlußkontakten bekannt.

Aufgabe der vorliegenden Erfindung ist es, hier Abhilfe zu schaffen und ein Halbleiterbauelement mit höckerartigen metallischen Anschlußkontakten und Mehrlagenverdrahtung zu schaffen, bei dem diese Unterbrechungen an Kanten sowie Bedampfungsspalte bzw. Fehlstellen nicht auftreten können und bei dem demzufolge auch die beschriebenen Kontaktverätzungen und Korrosion sicher vermieden werden.

Diese Aufgabe wird bei einem Halbleiterbauelement der eingangs genannten Art erfindungsgemäß durch die kennzeichnenden Merkmale des Patentanspruches 1 gelöst.

Dadurch gelingt es, beim Ätzen der erwähnten Isolierschichten Stufen mit einer solchen Höhe zu schaffen, die Leitbahnunterbrechungen sowie beim Aufdampfen der Anschlußkontakte das Entstehen von Bedampfungsspalten und Fehlstellen zu verhindern.

Ausgestaltungen des erfindungsgemäßen Halbleiterbauelementes sind in Unteransprüchen gekennzeichnet.

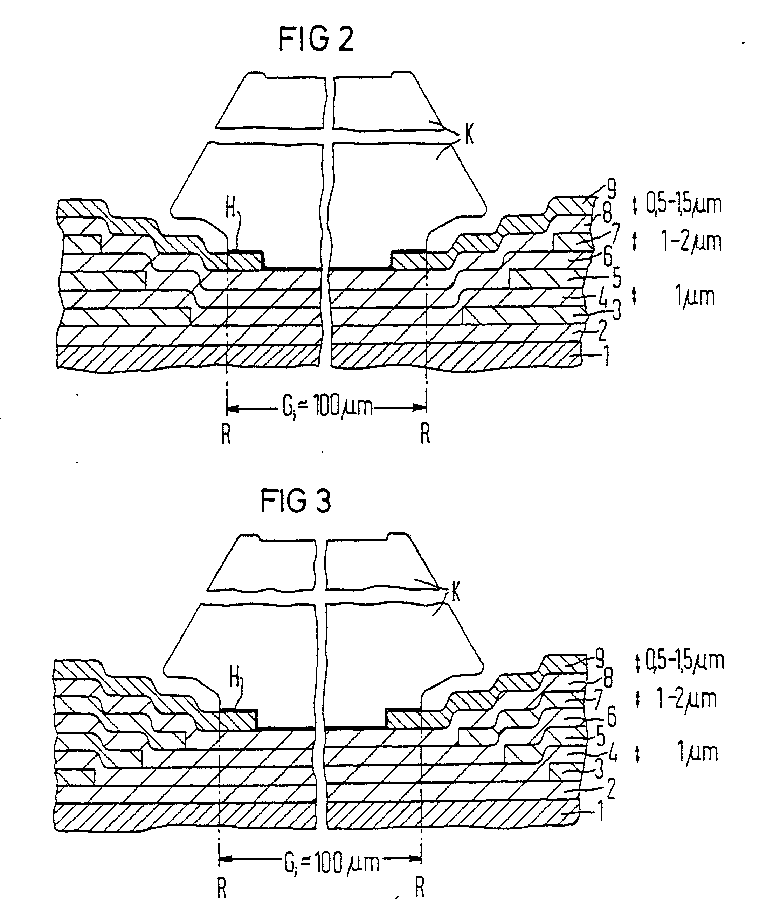

Die Erfindung wird im folgenden anhand der vorteilhaften Ausführungsformen der Figuren 2 und 3 näher·erläutert:

Fig. 2 stellt einen Ausschnitt aus einem erfindungsgemäßen Halbleiterbauelement im Querschnitt dar.

Fig. 3 stellt einen ebensolchen Ausschnitt aus einer anderen Weiterbildung eines erfindungsgemäßen Halbleiterbauelementes dar.

In den Figuren sind gleiche Elemente mit gleichen Bezugszeichen benannt.

Das erfindungsgemäße Halbleiterbauelement nach Fig. 2 enthält im dargestellten Bereich einen höckerartigen, metallischen Anschlußkontakt K mit der dünnen Haftschicht H und daran anschließende Leitbahnen 2, 4, 6, 8 und Isolierschichten 3, 5, 7 samt Endpassivierung 9, wobei sich die jeweiligen Abstände zwischen den Enden der einzelnen Isolierschichten 3, 5, 7 und einer gedachten, senkrechten Projektionslinie R des Randes der Grundfläche G des Anschlußkontaktes K auf eine Grundschicht 1 von oben nach unten stufenförmig verkleinern, so daß diese Enden der Isolierschichten 3, 5, 7 einen sich stufenförmig nach unten verjüngenden Trichter bilden. Bei der Herstellung des erfindungsgemäßen Halbleiterbauelementes wird auf diese Grundschicht 1, beispielsweise eine Oxisschicht, ganzflächig eine Leitbahn 2, beispielsweise bestehend aus Aluminium, aufgebracht. Auf diese Leitbahn 2 wird zunächst ganzflächig eine erste Isolierschicht 3 in einer Dicke von höchstens 2 µm, vorzugsweise jedoch vom 1 µm, aufgetragen. Diese kann beispielsweise aus einem Polyimidlack bestehen und nach üblichen Belackungstechniken aufgebracht werden. Im Bereich um die Projektionslinie R des nach unten projizierten Randes der Grundfläche G des späteren Anschlußkontaktes K wird diese Isolierschicht 3 dann nach üblichen fotolithographischen Verfahren wieder abgelöst, beispielsweise durch Ätzen, so daß die darunterliegende Leitbahn 2 z. T. freigelegt wird. Jetzt wird, wiederum ganzflächig, eine zweite Leitbahn 4 aufgebracht, die natürlich mit dem durch den vorherbeschriebenen Ablösevorgang entstandenen Rand der Isolierschicht 3 eine Stufe bildet, die jedoch wegen ihrer geringen Höhe von kleiner gleich 2 µm, vorzugsweise kleiner gleich 1 µm, nicht stört.

Auf diese Leitbahn 4 wiederum wird dann eine Isolierschicht 5 ganzflächig aufgebracht. Dann wird der Teil der Isolierschicht 5, der über dem abgelösten Bereich der Isolierschicht 3 liegt, sowie zusätzlich ein sich daran seitlich anschließender Bereich, dessen Breite mindestens das Doppelte der Stärke dieser oder der zuvor aufgebrachten Isolierschicht 3 beträgt, wiederum abgelöst. Sind die erwähnten Isolierschichten 3, 5 unterschiedlich dick, so wird vorzugsweise als Bezugsmaß für den zusätzlich abzulösenden Teil die Stärke der dickeren der beiden Isolierschichten 3, 5 verwendet. Anschließend werden analog zur Leitbahn 4 und der Isolierschicht 5 alternativ weitere Leitbahnen und Isolierschichten aufgetragen, die Isolierschichten entsprechend teilweise wieder abgelöst, so lange, bis alle benötigten Leitbahnen auf das Halbleiterbauelement aufgebracht sind. Abschließend wird dann eine sogenannte Endpassivierung 9 aufgetragen, die unterhalb der Grundfläche G des künftigen Anschlußkontaktes K in einem kleineren Bereich als dem dieser Grundfläche G wieder abgelöst wird. Daraufhin werden, wie eingangs beschrieben, die Haftschicht H und die Anschlußkontakte K aufgebracht. Zu erwähnen ist, daß die Anzahl der Leitbahnen nicht auf die in den Figuren dargestellten· vier Lagen beschränkt ist. Ebenfalls beispielhaft sind die in den Figuren dargestellten Maße der Anschlußkontakte, der Leitbahnen und Isolierschichten, jedoch sollte erfindungsgemäß jede der Isolierschichten 3, 5, 7 in der gezeichneten Umgebung der Anschlußkontakte K höchstens 2 µm dick sein, vorzugsweise sogar höchstens 1 µm. Auf diese Art und Weise kommen einerseits alle Leitbahnen 2, 4, 6, 8 unter die Anschlußkontakte K zu liegen und andererseits werden an den Enden der Isolierschichten 3, 5, 7 zu hohe Stufen, wie in Fig. 1 als Stand der Technik dargestellt, vermieden. Außerdem ist jede der Stufen, die an der Oberfläche des erfindungsgemäßen Halbleiterbauelementes auf der Endpassivierungsschicht 9 in der Umgebung der Anschlußkontakte K auftreten, höchstens genauso hoch wie die Stärke der dicksten der Isolierschichten 3, 5, 7. Durch die erfindungsgemäße Anordnung der Isolierschichten 3, 5, 7 werden also an den Leitbahnen 4, 6, 8 Leitbahnunterbrechungen U und an den Anschlußkontakten K Bedampfungsspalte S und Fehlstellen zuverlässig verhindert.

Die erfindungsgemäße Ausführungsform nach Fig. 3 ist ganz ähnlich gestaltet, nur sind die Flächen der abzulösenden Teile der einzelnen Isolierschichten 3, 5, 7 im Bereich der Anschlußkontakte K nicht von unten nach oben vergrößert, wie in Fig. 2 dargestellt, sondern, ebenfalls stufenförmig nach Art eines Trichters, umgekehrt von oben nach unten.

**Patentansprüche**

1. Halbleiterbauelement mit höckerartigen, metallischen Anschlußkontakten und Mehrlagenverdrahtung, dessen verschiedene Leitbahnen eines jeden in Mehrlagentechnik zu verdrahtenden elektrischen Signales bzw. Potentiales, mit Ausnahme mindestens eines Teilbereiches unter einer Grundfläche der entsprechend zugehörigen Anschlußkontakte jeweils durch mindestens eine Isolierschicht elektrisch voneinander getrennt sind, wobei besagte Grundfläche definiert ist als horizontale Schnittfläche durch den betreffenden Anschlußkontakt in der Höhe, in der dieser die größte horizontale Ausdehnung auf einer darunterliegenden Endpassivierungsschicht besitzt, dadurch gekennzeichnet, daß die einzelnen Isolierschichten (3, 5, 7) in horizontaler Richtung unterschiedlich entfernt von einer gedachten, senkrechten Projektionslinie (R) des Randes der Grundfläche (G) des zugehörigen Anschlußkontaktes (K) enden.

2. Halbleiterbauelement nach Anspruch 1, dadurch gekennzeichnet, daß der Unterschied der Entfernungen jeweils zweier benachbarter Isolierschichten (3, 5 bzw. 5, 7) zu der Projektionslinie (R) mindestens das Doppelte der Schichtdicke einer der beiden Isolierschichten (3, 5 bzw. 5, 7) beträgt.

3. Halbleiterbauelement nach Anspruch 2, dadurch gekennzeichnet, daß als Bezugswert für den Unterschied der Entfernungen jeweils zweier benachbarter, unterschiedlich dicker Isolierschichten (3, 5 bzw. 5, 7) die Stärke der dickeren der Isolierschichten (3, 5 bzw. 5, 7) verwendet wird.

4. Halbleiterbauelement nach einem der Ansprüche 1 bis 3, dadurch gekennzeichnet, daß jede der Isolierschichten (3, 5, 7) zwischen den Leitbahnen (2, 4, 6, 8) in den die Anschlußkontakte (K) umgebenden Bereichen höchstens 2 μm dick ist.

5. Halbleiterbauelement nach einem der Ansprüche 1 bis 3, dadurch gekennzeichnet, daß jede der Isolierschichten (3, 5, 7) zwischen den Leitbahnen (2, 4, 6, 8) in den die Anschlußkontakte (K) umgebenden Bereichen höchstens 1 μm dick ist.

6. Halbleiterbauelement nach einem der Ansprüche 1 bis 5, dadurch gekennzeichnet, daß um die Anschlußkontakte (K) herum die Enden der Isolierschichten (3, 5, 7) stufenförmig sich nach unten verjüngende Trichter bilden.

7. Halbleiterbauelement nach einem der Ansprüche 1 bis 5, dadurch gekennzeichnet, daß um die Anschlußkontakte (K) herum die Enden der Isolierschichten (3, 5, 7) stufenförmig sich nach unten vergrößernde Trichter bilden.

## Claims

1. Semi-conductor component having metallic bump contact and multi-layer wiring, whose various conductor tracks of an electrical signal or potential, each of which is to be wired in multilayer technique, are electrically isolated from each other in each case by at least one insulating layer with the exception of at least one part region under a base area of the corresponding associated contacts, said base area being defined as the horizontal sectional area through the respective contact at the level where the latter exhibits the greatest horizontal extent on an underlying end passivation layer, characterized in that the individual insulating layers (3, 5, 7) end in the horizontal direction at different distances from an ideal, vertical projection line (R) of the edge of the base area (G) of the associated contact (K).

2. Semi-conductor component according to Claim 1, characterized in that the difference in the distances from in each case two adjacent insulating layers (3, 5 or 5, 7) to the projection line (R) is at least double the layer thickness of one of the two insulating layers (3, 5 or 5, 7).

3. Semi-conductor component according to Claim 2, characterized in that the thickness of the thicker of the insulating layers (3, 5 or 5, 7) is used as the reference value for the difference in the distances in each case between two adjacent insulating layers (3, 5 or 5, 7) of different thicknesses.

4. Semi-conductor component according to one of Claims 1 to 3, characterized in that each of the insulating layers (3, 5, 7) between the conductor tracks (2, 4, 6, 8) in the regions surrounding the contacts (K) is 2 μm thick at the most.

5. Semi-conductor component according to one of Claims 1 to 3, characterized in that each of the insulating layers (3, 5, 7) between the conductor tracks (2, 4, 6, 8) in the regions surrounding the contacts (K) is 1 μm thick at the most.

6. Semi-conductor component according to one of Claims 1 to 5, characterized in that around the contacts (K) the ends of the insulating layers (3, 5, 7) form in a step-like manner a funnel narrowing towards the bottom.

7. Semi-conductor component according to one of Claims 1 to 5, characterized in that around the contacts (K) the ends of the insulating layers (3, 5, 7) form in a step-like manner a funnel widening towards the bottom.

## Revendications

1. Composant semi-conducteur comprenant des contacts métalliques de raccordement semblables à des protubérances et un câblage multicouche dont différentes pistes conductives coordonnées au même signal ou potentiel électrique, dans un câblage selon une technique multi-couche, à l'exception d'au moins une zone partielle sous une aire de base des contacts de raccordement correspondants, sont électriquement séparées l'une de l'autre par au moins une couche isolante, ladite aire de base étant définie comme l'aire de section horizontale du contact de raccordement concerné à la hauteur où ce contact possède l'étendue horizontale maximale sur une couche de passivation finale sous-jacente, caractérisé en ce que les différentes couches isolantes (3, 5, 7) se terminent, en direction horizontale, à des éloignements différents d'une ligne verticale fictive (R) de projection du bord de l'aire de base (G) du contact de raccordement (K) correspondant.

2. Composant selon la revendication 1, caractérisé en ce que la différence des éloignements de deux couches isolantes voisines (3, 5 ou 5, 7) de la ligne de projection (R) est au moins égale au double de l'épaisseur d'une des deux couches isolantes (3, 5 ou 5, 7).

3. Composant selon la revendication 2, caractérisé en ce que la valeur de référence utilisée pour la différence des éloignements de deux couches isolantes voisines (3, 5 ou 5, 7) d'épaisseurs différentes, est l'épaisseur de la couche isolante (3, 5 ou 5, 7) la plus épaisse.

4. Composant selon une des revendications 1 à 3, caractérisé en ce que chacune des couches isolantes (3, 5, 7) entre les pistes conductives (2, 4, 6, 8) possède une épaisseur de tout au plus 2 $\mu$m dans les zones entourant les contacts de raccordement (K).

5. Composant selon une des revendications 1 à 3, caractérisé en ce que chacune des couches isolantes (3, 5, 7) entre les pistes conductives (2, 4, 6, 8) possède une épaisseur de tout au plus 1 $\mu$m dans les zones entourant les contacts de raccordement (K).

6. Composant selon une des revendications 1 à 5, caractérisé en ce que les extrémités des couches isolantes (3, 5, 7) autour des contacts de raccordement (K) forment des entonnoirs qui se rétrécissent de façon échelonnée vers le bas.

7. Composant selon une des revendications 1 à 5, caractérisé en ce que les extrémités des couches isolantes (3, 5, 7) autour des contacts de raccordement (K) forment des entonnoirs qui s'évasent de façon échelonnée vers le bas.

# FIG 1

15–20 µm

0,5–1,5 µm

1–2 µm · >3 µm

1 µm

$G_i \approx 100\,\mu m$

## FIG 2

9
8    ‡ 0,5-1,5 μm
7    ‡ 1-2 μm
6
5
4    ‡ 1 μm
3
2
1

H

K

$G_i \approx 100\,\mu m$

R        R

## FIG 3

9    ‡ 0,5-1,5 μm
8
7    ‡ 1-2 μm
6
5
4    ‡ 1 μm
3
2
1

H

K

$G_i \approx 100\,\mu m$

R        R

2